# EUROPÄISCHE PATENTSCHRIFT

(11) **EP 1 374 266 B1**
(45) Veröffentlichungstag und Bekanntmachung des Hinweises auf die Patenterteilung: **20.06.2007**
(21) Anmeldenummer: 02732337.7
(22) Anmeldetag: 22.03.2002
(51) Int. Cl.: H01H 9/06, H05K 1/05

(54) **TRÄGER FÜR EINE ELEKTRISCHE SCHALTUNG, INSBESONDERE FÜR EINEN ELEKTRISCHEN SCHALTER**
SUPPORT FOR AN ELECTRICAL CIRCUIT IN PARTICULAR AN ELECTRICAL BREAKER
SUPPORT POUR CIRCUIT ELECTRIQUE, EN PARTICULIER POUR COMMUTATEUR ELECTRIQUE

(30) Priorität: 24.03.2001 DE 10114572
(43) Veröffentlichungstag der Anmeldung: 02.01.2004
(73) Patentinhaber: Marquardt GmbH, 78604 Rietheim-Weilheim (DE)
(72) Erfinder: BROGHAMMER, Peter, 78573 Wurmlingen (DE); WAHL, Peter, 78056 Villingen-Schwenningen (DE)
(74) Vertreter: Eisele, Otten, Roth & Dobler
(86) Internationale Anmeldenummer: PCT/DE2002/001044
(87) Internationale Veröffentlichungsnummer: WO 2002/078029

(56) Entgegenhaltungen:
- DE-A- 3 629 976
- DE-A- 10 019 471
- DE-A- 19 641 397
- US-A- 5 198 693

## Beschreibung

Die Erfindung betrifft einen elektrischen Schalter nach dem Oberbegriff des Patentanspruchs 1.

Auf einer Platine angeordnete elektrische Schaltungen besitzen einen weiten Einsatzbereich, beispielsweise in Steuergeräten, Elektrohaushaltsgeräten oder Elektrowerkzeugen. Insbesondere sind solche Schaltungen, die zur Ansteuerung eines Elektromotors in einem Elektrowerkzeug dienen, mit der platine im Gehäuse des Schalters für das Elektrowerkzeug angeordnet.

Eine derartige elektrische Schaltungsanordnung besteht aus elektrischen und/oder elektronischen Bauelementen. Die Bauelemente sind auf einem Trägersubstrat angeordnet, wobei sich die Leiterbahnen zur elektrischen Verbindung der Bauelemente ebenfalls auf dem Trägersubstrat befinden. Bin Schalter für ein Elektrowerkzeug, und zwar für ein Akku-Elektrowerkzeug, in dessen Gehäuse das Trägersubstrat der Ansteuerschaltung untergebracht ist, ist beispielsweise in der DE 41 14 854 A1 gezeigt. Das Trägersubstrat besteht aus einer Leiterplatte, beispielsweise in Hartpapier- oder FR4-Technik, oder auch aus einer Keramikplatte.

Während des Betriebs der elektrischen Schaltungsanordnung wird wärme in den Bauelementen erzeugt. Diese Verlustwärme muß abgeführt werden, was über die Leiterplatte und einen Kühlkörper geschieht, um thermische Beschädigungen der Bauelemente und dadurch eine Zerstörung der Schaltungsanordnung zu verhindern. Es hat sich heransgestellt, daß bei schaltungsanordnungen mit höherer Verlustwärme, die Leiterplatten die effektive Abfuhr der Wärme begrenzen. Insbesondere bei elektrischen Schaltern für Elektrowerkzeuge mit großer Leistung, bei denen eine Schaltungsanordnung zur Drehzahisteuerung, zur Drehmomentabschaltung o. dgl, im Gehäuse des Schalters angeordnet ist, haben sich entsprechende Beeinträchtigungen bis hin zum vorzeitigen Ausfall des Schalters ergeben. Vor allem ist dieses Problem bei Akku-Elektrowerkzeugen relevant, wo hohe Ströme durch den Schalter fließen.

Aus der DE 100 19 471 A1 ist weiter ein elektrischer Schalter für Elektrowerkzeuge mit einem aus zwei Gehäusehälften bestehenden Gehäuse bekannt, wobei eine Gehäusehälfte aus Metall hergestellt ist. Im Inneren des Gehäuses befindet sich eine elektrische Schaltungsanordnung auf einem Trägersubstrat. Das Trägersubstrat liegt an der aus Metall bestehenden Gehäusehälfte an, so daß diese Gehäusehälfte als Kühlkörper wirkt. Da das Trägersubstrat jedoch wiederum in herkömmlicher Art aus Keramikmaterial, Kunststoff o. dgl. besteht, ist auch hier die Abführung der Verlustwärme begrenzt.

Schließlich ist aus der DE 36 29 976 A1 ein Spannungsregler für einen Generator in einem Kraftfahrzeug bekannt. Der Spannungsregler ist als Hybridschaltung aus diversen Bauteilen und einem Leistungshalbleiter auf einer Trägerplatte angeordnet. Die Trägerplatte besteht aus gut wärmeleitendem Material, beispielsweise Stahl, Aluminium oder Kupfer, und besitzt einen dünnen, elektrisch isolierenden Überzug. Da die Trägerplatte als Metallteil ausgebildet ist, ist zwar für eine verbesserte Abfuhr der Verlustwärme gesorgt. Jedoch gibt der großbauende Spannungsregler für das Kraftfahrzeug keine Hinweise zur Anordnung einer metallischen Trägerplatte in einem kleinbauenden Gehäuse eines elektrischen Schalters.

Der Erfindung liegt die Aufgabe zugrunde, einen eine elektrische Schaltungsanordnung enthaltenden elektrischen Schalter mit einer verbesserten Wärmeabfuhr zu schaffen. Insbesondere soll ein in einem Elektrowerkzeug mit hoher Leistung eingesetzter elektrischer Schalter in dieser Hinsicht verbessert werden.

Diese Aufgabe wird bei einem gattungsgemäßen elektrischen Schalter durch die kennzeichnenden Merkmale des Anspruchs 1 gelöst.

Bei dem erfindungsgemäßen elektrischen Schalter besteht das Trägersubstrat für die Schaltungsanordnung aus einem Metallteil. Auf eine Oberfläche des Metallteils, und zwar insbesondere auf die den Bauelementen sowie den Leiterbahnen zugewandte Oberfläche, ist eine elektrisch isolierende Beschichtung aufgebracht. Wenigstens ein Bauelement und/oder wenigstens eine Leiterbahn befinden sich auf der Beschichtung. Eine derartige schaltungsanordnung gestattet eine besonders effiziente Abfuhr der in den Bauelementen erzeugten Verlustwärme. Weitere Ausgestaltungen der Erfindung sind Gegenstand der Unteransprüche.

Bevorzugterweise besteht das Metallteil aus Aluminium oder einer Aluminium-Legierung, beispielsweise aus einer AlMg3-Legierung. Als elektrisch isolierende Beschichtung bietet sich eine Eloxalschicht an, die insbesondere eine Dicke von ca. 30 bis 50 µm besitzt. Eine solche Eloxalschicht weist sowohl eine gute Wärmeleitfähigkeit als auch eine gute elektrische Isolierung auf und eignet sich daher besonders für den erfindungsgemäßen elektrischen Schalter.

Das Metallteil kann jedoch auch aus einem sonstigen gut wärmeleitfähigen Metall, wie Kupfer, Stahl o. dgl., oder einer Metall-Legierung bestehen. Das Metallteil ist zweckmäßigerweise als Platte ausgebildet, wobei deren Dicke beispielsweise mindestens 2 mm beträgt. Für die elektrisch isolierende Beschichtung bietet sich eine Keramikschicht an. Das Keramikmaterial, bei dem es sich insbesondere um eine Keramikpaste handelt, kann auf die Oberfläche des Metallteils aufgedruckt, aufgewalzt, aufgesprüht o. dgl. werden. Falls erforderlich kann anschließend diese Schicht eingebrannt werden. Auch eine Polymerschicht, wie eine Epoxyd-Schicixt o. dgl., kommt als elektrisch isolierende Beschichtung in Frage. Das Polymermaterial, bei dem es sich insbesondere um ein Polymerharz handelt, kann auf die oberfläche des Metallteils aufgedruckt, aufgespritzt, aufgewalzt o. dgl. werden. Falls erforderlich wird diese Schicht anschließend ausgehärtet. Schließlich ist möglich, für die elektrisch isolierende Beschichtung eine Folie, insbesondere eine Kunststoff-Folie, zu verwenden. Das Folienmaterial kann auf die Oberfläche des Metallteils aufgeklebt, auflaminiert o. dgl. werden. Die genannten Beschichtungen zeichnen sich durch einfache Herstellung aus. Zudem ist es mit einer derartigen elektrisch isolierenden Beschichtung möglich, für Gleichstromanwendungen eine elektrische Durchschlagfestigkeit von mindestens 400 V und für Wechselstromanwendungen eine elektrische Durchschlagsfestigkeit von mindestens 2 kV zu erreichen.

In einer Einzelteile einsparenden Weiterbildung ist das Metallteil selbst in der Art eines Kühlkörpers ausgestaltet. Es können dann Kühlrippen an der der elektrisch isolierenden Beschichtung abgewandten Oberfläche angebracht sein. Ein solches Metallteil kann aus einem Strangpreßkörper hergestellt sein.

Für die einfache Herstellung der Leiterbahnen auf der elektrisch isolierenden Beschichtung bietet sich die Dickschicht-Technik an. Hierzu bestehen die Leiterbahnen aus Kupfer, Silber-Palladium o. dgl., wobei die Paste, wie die Kupferpaste, Silber-Palladium-Paste o. dgl. entsprechend dem Layout für die Leiterbahnen auf die Beschichtung aufgebracht wird. Ebenso können gedruckte Widerstände mittels einer Widerstandspaste auf die Beschichtung aufgebracht werden. Anschließend werden die Leiterbahnen und/oder die gedruckten Widerstände eingebrannt. Das Auflöten der. Bauelemente auf die elektrisch isolierende Beschichtung kann im Vakuum erfolgen.

Oft handelt es sich wenigstens bei einem Bauelement der Schaltungsanordnung um einen Leistungshalbleiter, womit eine erhöhte Verlustwärme entsteht. In einem solchen Fall kann die Beschichtung eine Aussparung aufweisen, derart daß der Leistungshalbleiter auf dem Metallteil direkt befestigt ist, was wiederum die Wärmeabfuhr verbessert. Um einen Wärmestau am Leistungshalbleiter selbst zu vermeiden, bietet es sich gegebenenfalls weiterhin an, den Leistungshalbleiter als ungehäusten Chip auszugestalten, wobei dieser eine Bondverbindung zur Leiterbahn auf der Beschichtung besitzt. Selbstverständlich kann, wenn es die Verlustwärme gestattet, der Leistungshalbleiter auch auf der Beschichtung befestigt sein.

Der erfindungsgemäße elektrische Schalter findet vor allem in Elektrowerkzeugen, wie in einem mit Gleichspannung betriebenen Akku-Elektrowerkzeug oder einem mit Wechselspannung betriebenen Elektrowerkzeug Verwendung. Der Schalter besitzt ein Gehäuse, in dem das Trägersubstrat angeordnet ist. Ebensogut kann das Trägersubstrat an einer Seite des Gehäuses, insbesondere als Gehäuseteil und/oder seitlicher Abschluß für das Gehäuse, angeordnet sein, womit das Trägersubstrat gleichzeitig als Träger für die Bauelemente und als Bestandteil des Gehäuses dient. Weiterhin kann das Trägersubstrat gleichzeitig als Kühlkörper dienen, indem die der Beschichtung abgewandte Oberfläche des Metallteils als Kühlkörper aus dem Gehäuse herausragt. Ein solches Multifunktionsteil vereinfacht den Schalter und spart Kosten.

Dient das Trägersubstrat gleichzeitig als Gehäuseteil, so bietet es sich an, dieses nichtplan und/oder räumlich in der Art eines Sockels auszugestalten. Damit ist eine einfache Handhabe bei der Montage des Schalters gewährleistet. Zur Komplettierung des Gehäuses ist ein weiteres Gehäuseteil, das insbesondere aus Kunststoff besteht, in der Art eines Deckels aufgesetzt. Durch entsprechende Ausgestaltung kann der Deckel abdichtend auf den Sockel aufgesetzt sein, womit eine verbesserte Staubdichtheit des Schalters erzielt wird.

Bei solchen elektrischen Schaltern für Elektrowerkzeuge ist häufig der Leistungshalbleiter, wie ein MOS-FET, ein Triac, ein Thyristor, eine Freilaufdiode o. dgl., zur Zuführung des elektrischen Stroms für den Elektromotor im Gehäuse angeordnet. In diesem Fall ist es zweckmäßig, wenigstens eine Aussparung in der Beschichtung vorzusehen, derart daß der Leistungshalbleiter auf dem Metallteil direkt befestigt ist. Das Befestigen des Leistungshalbleiters kann wiederum durch Auflöten auf das Metallteil erfolgen. Damit gelingt eine wirksame wärmeabfuhr aus dem Schalterinneren, was die Lebensdauer des Schalters erhöht. Zusätzlich kann eine Widerstandsbahn für ein Potentiometer auf der Beschichtung mittels einer einbrennbaren Widerstandspaste aufgebracht sein.

Die mit der Erfindung erzielten Vorteile bestehen insbesondere darin, daß eine verbesserte wärmeabfuhr aus dem mit einer solchen Schaltungsanordnung ausgestatteten Schalter gegeben ist. Dadurch arbeitet der Schalter betriebssicherer. Es kommt zu weniger vorzeitigen Ausfällen und die Lebensdauer des Schalters wird verlängert.

Der elektrische Schalter ist für den Betrieb mit hoher Leistung geeignet. Insbesondere kann die Schaltungsanordnung im Gehäuse des elektrischen Schalters auch bei den Leistungen angeordnet werden, wo bisher die Schaltungsanordnung separat vom Schalter im Elektrowerkzeug, beispielsweise im Kühlluftstrom für den Elektromotor anzuordnen war.

Außerdem sind mit der Erfindung Kosteneinsparungen zu realisieren, da kein separater Kühlkörper notwendig ist. Wegen des Verzichts auf einen separaten Kühlkörper verringert sich auch die Baugröße der gesamten Anordnung Der Schalter läßt sich dann auch in engen Einbauräumen, wie beispielsweise in einem schmalen Handgriff eines Elektrowerkzeugs unterbringen.

Ausführungsbeispiele der Erfindung sind mit verschiedenen Weiterbildungen und Ausgestaltungen in den Zeichnungen dargestellt und werden im folgenden näher beschrieben.

Es zeigen
- Fig. 1: einen elektrischen Schalter in Seitenansicht,
- Fig. 2: eine Schnitt entlang der Linie 2-2 in Fig. 1,
- Fig. 3: einen Schnitt wie in Fig. 2 gemäß einer weiteren Ausgestaltung,
- Fig. 4: eine Draufsicht auf das Trägersubstrat gemäß Fig. 3 als Einzelteil,
- Fig. 5: einen Schnitt wie in Fig. 2 gemäß einem weiteren Ausführunsgsbeispiel und
- Fig. 6: einen Schnitt wie in Fig. 2 entsprechend einem noch weiteren Ausführungsbeispiel.

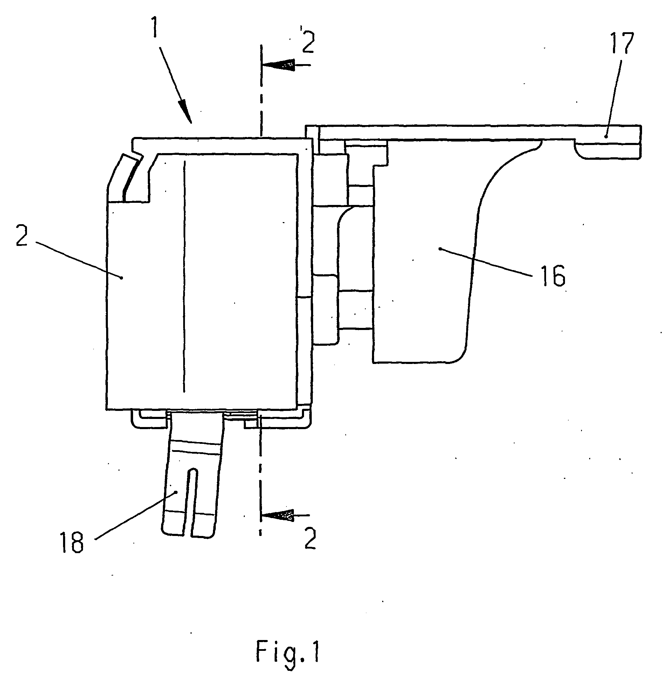

In Fig. 1 ist ein elektrischer Schalter 1 zu sehen, der für ein Elektrowerkzeug, und zwar insbesondere für ein mit Gleichspannung betriebenes Akku-Elektrowerkzeug zu verwenden ist. Der Schalter 1 besitzt ein Gehäuse 2, ein in der Art eines Drückers ausgebildetes, am Gehäuse 2 beweglich angeordnetes Betätigungsorgan 16 für die manuelle Betätigung des Elektrowerkzeugs durch den Benutzer, ein in der Art eines Umschalthebels ausgebildetes Betätigungselement 17 zur Umschaltung des Rechts-Links-Laufs für das Elektrowerkzeug sowie am Gehäuse 2 angeordnete Anschlußklemmen 18 zur elektrischen Verbindung mit dem Akku. Selbstverständlich kann ein solcher Schalter 1 bei entsprechender Ausgestaltung, was nachfolgend noch näher verdeutlicht wird, auch für ein mit Wechselspannung betriebenes Elektrowerkzeug verwendet werden.

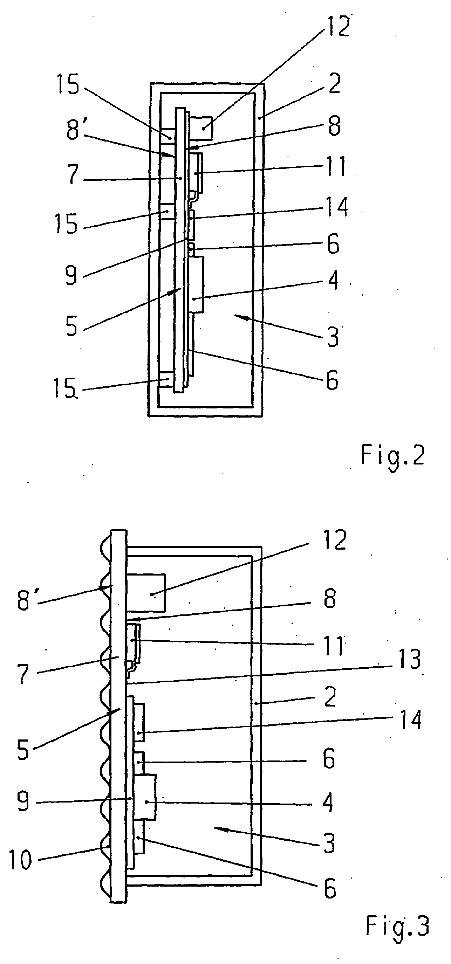

Wie weiter in Fig. 2 schematisch dargestellt ist, ist im Gehäuse 2 eine elektrische Schaltungsanordnung 3 zur Steuerung der Drehzahl des Elektromotors im Elektrowerkzeug angeordnet. Die Schaltungsanordnung 3 kann auch eine Drehmomentabschaltung des Elektromotors, die beispielsweise für Schraubarbeiten mit dem Elektrowerkzeug verwendbar ist, oder eine sonstige Funktionalität des Elektrowerkzeugs beinhalten. Die Schaltungsanordnung 3 enthält damit zumindest einen Teil der Steuerelektronik für den Elektromotor des Elektrowerkzeugs. Das Gehäuse 2 nimmt in bekannter Weise noch weitere Teile des Schalters 1 auf, wie das Kontaktsystem o. dgl., was jedoch nicht weiter gezeigt ist.

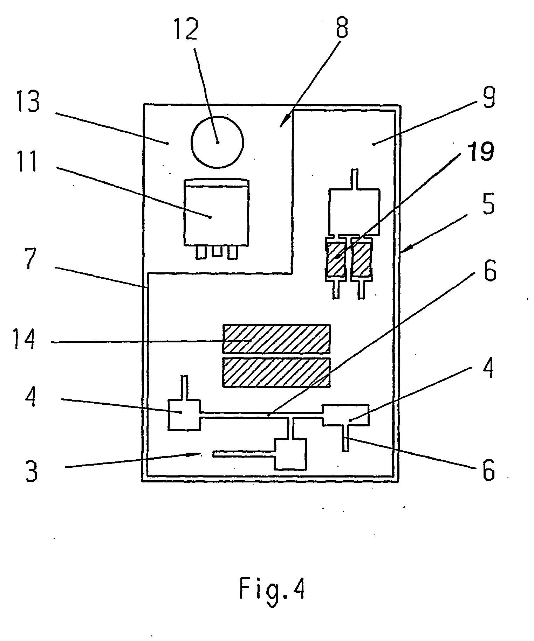

Die Schaltungsanordnung 3 weist elektrische und/oder elektronische Bauelemente 4 auf, die auf einem Trägersubstrat 5 angeordnet sind. Auf dem Trägersubstrat 5 befinden sich weiterhin die zu den Bauelementen 4 o. dgl. führenden, und deren elektrische Verbindung herstellenden Leiterbahnen 6, was auch näher aus Fig. 4 ersichtlich ist. Erfindungsgemäß besteht das Trägersubstrat 5 aus einem Metallteil 7. Auf eine Oberfläche 8 des Metallteils 7, und zwar insbesondere auf die den Bauelementen 4 sowie den Leiterbahnen 6 zugewandte Oberfläche 8, ist eine elektrisch isolierende, also nichtleitende Beschichtung 9 aufgebracht. Auf der Beschichtung 9 befindet sich wenigstens ein Bauelement 4 und/oder wenigstens eine Leiterbahn 6 der Schaltungsanordnung 3. Bevorzugterweise sind die meisten der Bauelemente 4, gegebenenfalls bis auf noch nachfolgend erläuterte Ausnahmen, sowie sämtliche Leiterbahnen 6 auf der Beschichtung 9 angeordnet, womit die Bauelemente 4 und die Leiterbahnen 6 aufgrund der elektrischen Isolation durch die Beschichtung 9 ohne elektrischen Kontakt zum Metallteil 7 sind.

In einer bevorzugten Ausgestaltung besteht das Metallteil 7 aus Aluminium oder auch aus einer Aluminium-Legierung. Als besonders geeignet hat sich hierfür beispielsweise eine AlMg3-Legierung erwiesen. Die elektrisch isolierende Beschichtung 9 besteht dann aus einer Eloxalschicht an der Oberfläche 8 des Aluminium-Metallteils 7. Zweckmäßigerweise besitzt die Eloxalschicht eine Dicke von ca. 30 bis 50 µm, derart daß einerseits eine gute Wärmeleitfähigkeit von den Bauelementen 4 zum Metallteil 7 und andererseits dennoch eine gute elektrische Isolierung zum Metallteil 7 gegeben ist.

Das Metallteil 7 kann auch aus Kupfer, Stahl oder einem sonstigen gut wärmeleitfähigen Metall oder einer Metall-Legierung bestehen. Weiter kann die elektrisch isolierende Beschichtung 9 aus einer Keramikschicht bestehen. Zur Herstellung der Keramikschicht läßt sich eine Keramikpaste als Keramikmaterial verwenden, die auf die Oberfläche 8 des Metallteils 7 aufgedruckt, aufgewalzt, aufgesprüht oder in sonstige Weise aufgebracht ist Falls notwendig kann dann anschließend die aufgebrachte Keramikpaste in die Oberfläche 8 eingebrannt werden. Ebenfalls geeignet ist eine Polymerschicht, beispielsweise eine Epoxyd-Schicht, für die Beschichtung 9. Das Polymermaterial kann beispielsweise als ungehärtetes Polymerharz auf die Oberfläche 8 des Metallteils 7 aufgedruckt, aufgespritzt, aufgewalzt oder in sonstiger Weise aufgebracht werden. Gegebenenfalls kann dann anschließend das Polymermaterial in bekannter Weise ausgehärtet werden. Ebenso kann eine Folie, wie eine Kunststoff-Folie, als Beschichtung 9 dienen. Das Folienmaterial wird dann auf die Oberfläche 8 des Metallteils 7 aufgeklebt, auflaminiert oder in sonstiger Weise aufgebracht.

Wie gefunden wurde, läßt sich in dieser Art und Weise die Beschichtung 9 für Gleichstromanwendungen so ausgestalten, daß eine elektrische Durchschlagfestigkeit von mindestens 400 V erreicht wird. Für Wechselstromanwendungen wird die Beschichtung 9 in einer solchen Dicke hergestellt, daß eine elektrische Durchschlagfestigkeit von mindestens 2000 V erzielt wird. Diese Mindest-Durchschagfestigkeiten können vor allem dann notwendig sein, wenn die Schaltungsanordnung 3 in einem elektrischen Schalter 1 eines Elektrowerkzeugs angeordnet ist.

Das Metallteil 7 kann eine beliebige, beispielsweise der Befestigung 15 im Gehäuse 2 angepaßte Form aufweisen. Häufig wird das Metallteil 7 als Platte ausgebildet sein, was anhand der Fig. 2 näher zu sehen ist. Zweckmäßigerweise beträgt die Dicke der Platte mindestens 2 mm, um eine gute Wärmeabfuhr zu gewährleisten. Weiter kann das Metallteil 7 auch in der Art eines Kühlkörpers ausgestaltet sein. In diesem Fall besitzt das Metallteil 7 Kühlrippen 10 an der der elektrisch isolierenden Beschichtung 9 abgewandten Oberfläche 8', wie in Fig. 3 gezeigt ist Um die Ausbildung als Kühlkörper zu vereinfachen, kann das Metallteil 7 aus einem Strangpreßkörper hergestellt sein.

Es bietet sich an, daß die Leiterbahnen 6 auf der elektrisch isolierenden Beschichtung 9 aus Kupfer, Silber-Palladium o. dgl. hergestellt werden. Hierfür kann dieses Material als entsprechende Paste, nämlich als Kupferpaste, Silber-Palladium-Paste o. dgl., auf die Beschichtung 9 in der Art einer Dickschicht-Technik aufgebracht werden. Das Aufbringen der Paste erfolgt entsprechend der für die Leiterbahnen 6 erforderlichen Struktur, beispielsweise durch Drucken. Anschließend wird die Paste dann, soweit notwendig, noch in die Beschichtung 9 eingebrannt Ebenso können die elektrischen Widerstände mittels einer Widerstandspaste aufgedruckt und in die Beschichtung 9 eingebrannt werden. Dies ist anhand der Widerstandsbahn 14 in Fig. 4 zu sehen. Das Auflöten der Bauelemente 4 auf die elektrisch isolierende Beschichtung. 9 erfolgt bevorzugterweise im Vakuum. Bei diesen Bauelementen kann es sich selbstverständlich auch um SMD-Bauelemente 19 handeln, wie ebenfalls in Fig. 4 zu sehen ist.

Wie weiter in Fig. 4 gezeigt ist, handelt es sich bei wenigstens einem der Bauelemente um einen Leistungshalbleiter 11, 12. Die Beschichtung 9 weist im Bereich des Leistungshalbleiters 11, 12 auf dem Trägersubstrat 5 eine Aussparung 13 auf. Der Leistungshalbleiter 11, 12 ist in der Aussparung 13 auf dem Metallteil 7 direkt befestigt, was beispielsweise durch Auflöten erfolgen kann. Da bei Elektrowerkzeugen im Leistungshalbleiter 11, 12 eine vergleichsweise große Verlustwärme entsteht, ist durch diese Maßnahme dafür gesorgt, daß die Verlustwärme effektiv abgeführt werden kann. Falls die Wärmeabfuhr ausreichend ist, kann der Leistungshalbleiter 11, 12 selbstverständlich auch auf der Beschichtung 9 befestigt sein. Zur weiteren Effektivitätssteigerung der Wärmeabfuhr kann der Leistungshalbleiter 11, 12 als ungehäuster Chip ausgestaltet sein, der beispielsweise eine Bondverbindung zu den entsprechenden Leiterbahnen 6 auf der Beschichtung 9 besitzt, was jedoch nicht weiter gezeigt ist

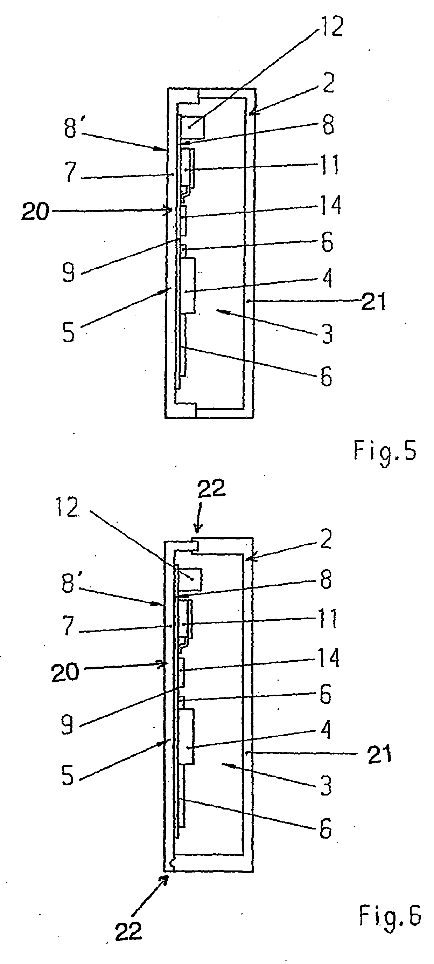

Wie bereits ausgeführt, ist das Trägersubstrat 5 im Gehäuse 2 des elektrischen Schalters 1 angeordnet. Zweckmäßigerweise befindet sich, wie in Fig. 2 dargestellt ist, das Trägersubstrat 5 an einer Seite des Gehäuses 2. Die der Beschichtung 9 abgewandte Oberfläche 8' des Metallteils 7 kann auch als Kühlkörper, insbesondere mit Kühlrippen 10' aus dem Gehäuse 2 herausragen, wie anhand der Fig. 3 zu erkennen ist. Gemäß einer in Fig. 5 oder 6 gezeigten weiteren Ausgestaltung kann das Trägersubstrat 5 selbst als ein Gehäuseteil ausgebildet sein. Dieses Gehäuseteil dient dann als seitlicher Abschluß für das Gehäuse 2, so daß die entsprechende Seitenwand im Gehäuse 2 entfällt. Entsprechend der . Gestaltung des Gehäuses 2 kann das als Gehäuseteil dienende Trägersubstrat 5 räumlich und somit nichtplan in der Art eines Sockels 20 ausgestaltet sein. Zur Komplettierung des Gehäuses 2 ist gemäß Fig. 5 ein weiteres Gehäuseteil in der Art eines Deckels 21 aufgesetzt, womit eine besonders einfache Montage des Schalters 1 erzielt wird. Der Deckel 21 kann in üblicher Weise aus Kunststoff bestehen, während der Sockel 20 aus dem Metallteil 7 besteht. Wie weiter in Fig. 6 gezeigt ist, kann durch eine entsprechende Gestaltung mittels einer Nut- und Federverbindung 22 eine einfache Abdichtung zwischen dem Sockel 20 und dem Deckel 21 erreicht werden. Selbstverständlich kann zwischen dem Sockel 20 und dem Deckel 21 auch noch eine zusätzliche Dichtung angeordnet sein, was jedoch nicht weiter gezeigt ist.

Handelt es sich um einen elektrischen Schalter 1 für ein Akku-Elektrowerkzeug mit einer hohen Leistung, so fließen dementsprechend hohe Ströme in der Leistungselektronik, was wiederum eine große Wärmeentwicklung nach sich zieht. Mit Hilfe der Erfindung läßt sich neben der Steuerelektronik auch die Leistungselektronik in der elektrischen Schaltungsanordnung 3 auf dem Trägersubstrat 5 im Gehäuse 2 unterbringen. Die Leistungselektronik in der Schaltungsanordnung 3 enthält wenigstens einen Leistungshalbleiter, wie einen MOS-FET 11 zur Stromzuführung entsprechend der eingestellten Drehzahl zum Elektromotor und/oder eine Freilaufdiode 12. Zwar lassen sich der MOS-FET 11 sowie die Freilaufdiode 12 auch auf der Beschichtung 9 anordnen, wie in Fig. 2 zu sehen ist. Bevorzugt ist in diesem Fall jedoch, daß die Beschichtung 9 wenigstens eine Aussparung 13 aufweist, derart daß der Leistungshalbleiter 11, 12 auf dem Metallteil 7 direkt befestigt ist, was in Fig. 3 und 4 näher dargestellt ist. Dies wird dadurch ermöglicht, weil der MOS-FET 11 und die Freilaufdiode 12, ein gemeinsames Potential in der Schaltungsanordnung 3 besitzen. Die aufgrund der hohen fließenden elektrischen Ströme große Wärmeentwicklung der beiden Leistungshalbleiter 11,12 wird dann ohne weiteren Wärmewiderstand direkt auf das Trägersubstrat 5 abgeleitet Vorteilhafterweise sind vom Trägersubstrat 5 zum eigentlichen Kontaktsystem im Schalter 1 nur noch wenige, und zwar drei elektrische Verbindungsstellen erforderlich, was den Montageaufwand für den Schalter 1 erheblich reduziert. Die Befestigung der Leistungshalbleiter 11, 12 auf dem Metallteil 7 erfolgt zweckmäßigerweise durch Auflöten.

Selbstverständlich kann auch bei einem Schalter 1 für ein netzbetriebenes Elektrowerkzeug, falls es die Wärmeentwicklung erfordert, der Leistungshalbleiter 11 in einer Aussparung 13 direkt auf dem Metallteil 7 befestigt sein. Da in diesem Fall das Elektrowerkzeug an Wechselspannung betrieben wird, handelt es sich bei dem Leistungshalbleiter 11 zur Stromzuführung entsprechend der Drehzahl des Elektromotors um einen Triac oder einen Thyristor. Schließlich befindet sich noch eine Widerstandsbahn 14 für ein Potentiometer auf der Beschichtung 9, wobei das Potentiometer mit Hilfe des in Fig. 1 gezeigten Betätigungsorgans 16 durch den Benutzer verstellt wird. Dadurch wird von der Widerstandsbahn 14 ein Sollsignal erzeugt, das der vom Benutzer über die Verstellung des Betätigungsorgans 16 gewählten Drehzahl des Elektromotors entspricht. Die Widerstandsbahn 14 ist beispielsweise mittels einer einbrennbaren Widerstandspaste auf der Beschichtung 9 aufgebracht.

Die Erfindung ist nicht auf die beschriebenen und dargestellten Ausführungsbeispiele einer Schaltungsanordnung 3 im Gehäuse 2 des elektrischen Schalters 1 beschränkt. Genausogut kann diese Schaltungsanordnung 3 auch an sonstiger zweckmäßiger Stelle im Elektrowerkzeug an sich angeordnet sein. Die Erfindung umfaßt auch alle fachmännischen Weiterbildungen im Rahmen der Schutzrechtsansprüche. So kann die Erfindung nicht nur für elektrische Schalter und Elektrowerkzeuge Verwendung finden, sondern kann vielmehr auch bei Schaltungsanordnungen auf Trägersubstraten für Steuergeräte, Elektrohaushaltsgeräte, Elektrogartengeräte, Werkzeugmaschinen o. dgl. eingesetzt werden.

### Bezugszeichen-Liste:

- 1:: elektrischer Schalter
- 2:: Gehäuse
- 3:: elektrische Schaltungsanordnung
- 4:: Bauelement
- 5:: Trägersubstrat
- 6:: Leiterbahn
- 7:: Metallteil
- 8,8':: Oberfläche (von Metallteil)
- 9:: (isolierende) Beschichtung (auf Metallteil)
- 10:: Kühlrippen
- 11:: MOS-FET / Leistungshalbleiter
- 12:: Freilaufdiode / Leistungshalbleiter
- 13:: Aussparung
- 14:: Widerstandsbahn
- 15:: Befestigung (von Metallteil)
- 16:: Betätigungsorgan
- 17:: Betätigungselement
- 18:: Anschlußklemmen
- 19:: SMD-Bauelement
- 20:: Sockel
- 21:: Deckel
- 22:: Nut- und Federverbindung

## Patentansprüche

1. Elektrischer Schalter, insbesondere für ein Elektrowerkzeug, wie ein mit Gleichspannung betriebenes Akku-Elektrowerkzeug oder ein mit. Wechselspannung betriebenes Elektrowerkzeug, mit einem Gehäuse (2), sowie mit einer im Gehäuse (2) angeordneten elektrischen Schaltungsanordnung (3), die elektrische und/oder elektronische Bauelemente (4), Leiterbahnen (6) zur elektrischen Verbindung der Bauelemente (4) o. dgl. und ein Trägersubstrat (5) aufweist, wobei die Bauelemente (4) sowie die Leiterbahnen (6) auf dem Trägersubstrat (5) angeordnet sind, **dadurch gekennzeichnet, daß** das Trägersubstrat (5) aus einem Metallteil (7) besteht, daß auf der den Bauelementen (4) sowie den Leiterbahnen (6) zugewandten Oberfläche (8) des Metallteils (7) eine elektrisch isolierende Beschichtung (9) aufgebracht ist, und daß wenigstens ein Bauelement (4) und/oder wenigstens eine Leiterbahn (6) sich auf der Beschichtung (9) befindet.

2. Elektrischer Schalter nach Anspruch 1, **dadurch gekennzeichnet, daß** das Metallteil (7) aus Aluminium oder einer Aluminium-Legierung, beispielsweise aus einer AlMg3-Legierung, besteht, und daß vorzugsweise die elektrisch isolierende Beschichtung (9) aus einer Eloxalschicht besteht, die insbesondere eine Dicke von ca. 30 bis 50 µm besitzt, derart, daß diese Eloxalschicht eine gute Wärmeleitfähigkeit und eine gute elektrische Isolierung aufweist.

3. Elektrischer Schalter nach Anspruch 1 oder 2, **dadurch gekennzeichnet, daß** das Metallteil (7) aus einem gut wärmeleitfähigen Metall, wie Kupfer, Stahl o. dgl., oder einer Metall-Legierung besteht.

4. Elektrischer.Schalter nach Anspruch 1, 2 oder 3, **dadurch gekennzeichnet, daß** die elektrisch isolierende Beschichtung (9) aus einer Keramikschicht besteht, wobei vorzugsweise das Keramikmaterial, insbesondere als Keramikpaste, auf die Oberfläche (8) des Metallteils (7) aufgedruckt, aufgewalzt, aufgesprüht o. dgl. und gegebenenfalls eingebrannt ist.

5. Elektrischer Schalter nach Anspruch 1, 2 oder 3, **dadurch gekennzeichnet, daß** die elektrisch isolierende Beschichtung (9) aus einer Polymerschicht, wie einer Epoxyd-Schicht o. dgl., besteht, wobei vorzugsweise das Polymermaterial, insbesondere als Polymerharz, auf die Oberfläche (8) des Metallteils (7) aufgedruckt, aufgespritzt, aufgewalzt o. dgl. und gegebenenfalls ausgehärtet ist.

6. Elektrischer Schalter nach Anspruch 1, 2 oder 3, **dadurch gekennzeichnet, daß** die elektrisch isolierende Beschichtung (9) aus einer Folie, insbesondere einer Kunststoff-Folie, besteht, wobei vorzugsweise das Folienmaterial auf die Oberfläche (8) des Metallteils (7) aufgeklebt, auflaminiert o. dgl. ist.

7. Elektrischer Schalter nach einem der Ansprüche 1 bis 6, **dadurch gekennzeichnet, daß** die elektrisch isolierende Beschichtung (9) für Gleichstromanwendungen eine elektrische Durchschlagfestigkeit von mindestens 400 V und für Wechselstromanwendungen eine elektrische Durchschlagsfestigkeit von mindestens 2000 V aufweist.

8. Elektrischer Schalter nach einem der Ansprüche 1 bis 7, **dadurch gekennzeichnet, daß** das Metallteil (7) als Platte ausgebildet ist, wobei deren Dicke beispielsweise mindestens 2 mm beträgt.

9. Elektrischer Schalter nach einem der Ansprüche 1 bis 8, **dadurch gekennzeichnet, daß** das Metallteil (7) in der Art eines Kühlkörpers, insbesondere mit Kühlrippen (10) an der der elektrisch isolierenden Beschichtung (9) abgewandten Oberfläche (8'), ausgestaltet ist, und daß vorzugsweise das Metallteil (7) aus einem Strangpreßkörper hergestellt ist.

10. Elektrischer Schalter nach einem der Ansprüche 1 bis 9, **dadurch gekennzeichnet, daß** die Leiterbahnen (6) auf der elektrisch isolierenden Beschichtung (9) aus Kupfer, Silber-Palladium o. dgl. bestehen, daß vorzugsweise die Leiterbahnen und/oder die gedruckten Widerstände (14) als entsprechende Paste, wie Kupferpaste, Silber-Palladium-Paste, Widerstandspaste o. dgl., in der Art einer Dickschicht-Technik auf die Beschichtung (9) aufgebracht sowie gegebenenfalls anschließend eingebrannt werden, und daß weiter vorzugsweise **das Auflöten der Bauelemente (4) auf die elektrisch** isolierende Beschichtung (9) im Vakuum erfolgt.

11. Elektrischer Schalter nach einem der Ansprüche 1 bis 10, **dadurch gekennzeichnet, daß** es sich bei wenigstens einem Bauelement um einen Leistungshalbleiter (11, 12) handelt, daß vorzugsweise die Beschichtung (9) eine Aussparung (13) aufweist, derart daß der Leistungshalbleiter (11, 12) auf dem Metallteil (7) direkt befestigt ist, oder der Leistungshalbleiter (11, 12) auf der Beschichtung (9) befestigt ist, und daß noch weiter vorzugsweise der Leistungshalbleiter (11, 12) als ungehäuster Chip ausgestaltet ist, der insbesondere eine Bondverbindung zur Leiterbahn (6) auf der Beschichtung besitzt.

12. Elektrischer Schalter nach einem der Ansprüche 1 bis 11,
**dadurch gekennzeichnet, daß** der Schalter (1) ein Gehäuse (2) aufweist, und daß das Trägersubstrat (5) im Gehäuse (2) und/oder an einer Seite des Gehäuses (2), insbesondere als Gehäuseteil und/oder seitlicher Abschluß für das Gehäuse (2), angeordnet ist, vorzugsweise derart, daß die der Beschichtung (9) abgewandte Oberfläche (8') des Metallteils (7) als Kühlkörper aus dem Gehäuse (2) herausragt.

13. Elektrischer Schalter nach einem der Ansprüche 1 bis 12, **dadurch gekennzeichnet, daß** das als Gehäuseteil dienende Trägersubstrat (5) nicht plan und/oder räumlich in der Art eines Sockels (20) ausgestaltet ist, vorzugsweise derart, daß ein weiteres Gehäuseteil, das insbesondere aus Kunststoff besteht, zur Komplettierung des Gehäuses (2) in der Art eines Deckels (21), insbesondere abdichtend, aufgesetzt ist.

14. Elektrischer Schalter nach einem der Ansprüche 1 bis 13, **dadurch gekennzeichnet, daß** die Schaltungsanordnung (3) wenigstens einen Leistungshalbleiter, wie einen MOS-FET (11), einen Triac, einen Thyristor, eine Freilaufdiode (12) o. dgl., enthält, daß vorzugsweise die Beschichtung (9) wenigstens eine Aussparung (13) aufweist, derart, daß der Leistungshalbleiter (11, 12) auf dem Metallteil (7) direkt befestigt, insbesondere aufgelötet ist, und daß weiter vorzugsweise eine Widerstandsbahn (14) für ein Potentiometer auf der Beschichtung (9), beispielsweise mittels einer einbrennbaren Widerstandspaste, aufgebracht ist.

## Claims

1. Electric switch, in particular for an electric tool, such as a battery-powered electric tool operated using d.c. voltage or an electric tool operated using a.c. voltage, comprising a housing (2), and an electric circuit arrangement (3) arranged in the housing (2), which comprises electric and/or electronic components (4), conductor tracks (6) for the electrical connection of the components (4) or the like, and a substrate (5), wherein the components (4) and the conductor tracks (6) are arranged on the substrate (5), **characterised in that** the substrate (5) consists of a metal part (7), **in that** an electrically insulating coating (9) is applied onto the surface (8) of the metal part (7) facing the components (4) and the conductor tracks (6), and **in that** at least one component (4) and/or at least one conductor track (6) is located on the coating (9).

2. Electric switch according to claim 1, **characterised in that** the metal part (7) is made of aluminium or an aluminium alloy, for example an AIMg3 alloy, and **in that** preferably the electrically insulating coating (9) is an anodized layer, which, in particular, has a thickness of approximately 30 to 50 µm, so that said anodized layer has high thermal conductivity and good electrical insulation.

3. Electric switch according to claim 1 or 2, **characterised in that** the metal part (7) is made from a metal with high thermal conductivity, such as copper, steel or the like, or from a metal alloy.

4. Electric switch according to claim 1, 2 or 3, **characterised in that** the electrically insulating coating (9) consists of a ceramic layer, with the ceramic material, in particular in the form of a ceramic paste, preferably being printed, rolled, sprayed or the like onto the surface (8) of the metal part (7) and if required burnt in.

5. Electric switch according to claim 1, 2 or 3, **characterised in that** the electrically insulating coating (9) consists of a polymer layer, such as an epoxy layer or the like, with the polymer material, in particular a polymer resin, preferably being printed, sprayed, rolled or the like onto the surface (8) of the metal part (7) and if necessary cured.

6. Electric switch according to claim 1, 2 or 3, **characterised in that** the electrically insulating coating (9) consists of a film, in particular a plastic film, with the film material preferably being adhesively bonded, laminated or the like onto the surface (8) of the metal part (7).

7. Electric switch according to one of claims 1 to 6, **characterised in that** the electrically insulating coating (9) has a dielectric strength of at least 400 V for DC applications, and a dielectric strength of at least 2000 V for AC applications.

8. Electric switch according to one of claims 1 to 7, **characterised in that** the metal part (7) is in the form of a plate with a thickness of, for example, at least 2 mm.

9. Electric switch according to one of claims 1 to 8, **characterised in that** the metal part (7) is designed in the form of a heat sink, in particular with cooling ribs (10) on the surface (8') facing away from the electrically insulating coating (9), and **in that** the metal part (7) is preferably produced from an extruded body.

10. Electric switch according to one of claims 1 to 9, **characterised in that** the conductor tracks (6) on the electrically insulating coating (9) are made of copper, silver palladium or the like, **in that** preferably the conductor tracks and/or the printed resistors (14) are applied onto the coating (9) in the form of a suitable paste, such as copper paste, silver palladium paste, resistance paste or the like, in a thick-film technique, and if required are then burnt in, and **in that**, furthermore, the components (4) are preferably soldered onto the electrically insulating coating (9) in a vacuum.

11. Electric switch according to one of claims 1 to 10, **characterised in that** at least one component is a power semiconductor (11, 12), **in that** preferably the coating (9) has a cutout (13), so that the power semiconductor (11,12) is secured directly onto the metal part (7), or the power semiconductor (11, 12) is secured on the coating (9), and **in that**, furthermore, the power semiconductor (11, 12) is preferably in the form of a chip without a housing, which in particular has a bond connection with the conductor track (6) on the coating.

12. Electric switch according to one of claims 1 to 11, **characterised in that** the switch (1) has a housing (2), and **in that** the substrate (5) is arranged in the housing (2) and/or on one side of the housing (2), in particular as a housing part and/or as a side closure for the housing (2), preferably such that that surface (8') of the metal part (7) facing away from the coating (9) projects out of the housing (2) as a heat sink.

13. Electric switch according to one of claims 1 to 12, **characterised in that** the substrate (5) functioning as a housing part is non-planar and/or is designed three-dimensionally in the form of a base (20), preferably so that a further housing part, made in particular of plastic, can be fitted on like a cover (21) to complete the housing (2), in particular so as to form a seal.

14. Electric switch according to one of claims 1 or 13, **characterised in that** the circuit arrangement (3) contains at least one power semiconductor such as a MOSFET (11), a TRIAC, a thyristor, a freewheeling diode (12) or the like, **in that** preferably the coating (9) comprises at least one cutout.(13), so that the power semiconductor (11, 12) is secured directly to the metal part (7), in particular is soldered onto it, and **in that** furthermore a resistance track (14) for a potentiometer is applied onto the coating (9), for example by means of a resistance paste that can be burnt in.

## Revendications

1. Commutateur électrique, en particulier pour un outil électrique, tel qu'un outil électrique avec accumulateur alimenté en courant continu ou un outil électrique alimenté en courant alternatif, comportant un boîtier (2) ainsi qu'un dispositif de circuit électrique (3) installé dans le boîtier (2) et ayant des composants électriques et/ou électroniques (4), des voies conductrices (6) pour le raccordement électrique des composants (4) ou analogues, et un substrat de support (5), et dont les composants (4) ainsi que les voies conductrices (6) sont montés sur le substrat de support (5),
**caractérisé en ce que**
le substrat de support (5) se compose d'une pièce métallique (7), un revêtement électriquement isolant (9) est déposé sur la surface (8) de la pièce métallique (7) tournée vers les composants (4) et vers les voies conductrices (6), et au moins un composant (4), et/ou au moins une voie conductrice (6) se trouve sur le revêtement (9).

2. Commutateur électrique selon la revendication 1,
**caractérisé en ce que**
la pièce métallique (7) est en aluminium ou en un alliage d'aluminium, par exemple un alliage AlMg3, et de préférence le revêtement électriquement isolant (9) se compose d'une couche anodisée, qui présente notamment une épaisseur d'environ 30 à 50 µm, de sorte que cette couche anodisée présente une bonne conductibilité thermique et une bonne isolation électrique.

3. Commutateur électrique selon la revendication 1 ou 2,
**caractérisé en ce que**
la pièce métallique (7) se compose d'un métal bon conducteur de la chaleur, comme le cuivre, l'acier ou analogue, ou d'un alliage métallique.

4. Commutateur électrique selon la revendication 1, 2 ou 3,
**caractérisé en ce que**
le revêtement électriquement isolant (9) se compose d'une couche céramique, dans lequel la matière céramique, en particulier sous forme de pâte céramique, est pressée, roulée, projetée ou analogue sur la surface (8) de la pièce métallique (7) et est éventuellement cuite.

5. Commutateur électrique selon la revendication 1, 2 ou 3,
**caractérisé en ce que**
le revêtement électriquement isolant (9) se compose d'une couche de polymère, telle qu'une couche d'époxy ou analogue, et la matière polymère, en particulier sous forme de résine polymère, est de préférence pressée, projetée, roulée ou analogue sur la surface (8) de la pièce métallique (7), et est éventuellement durcie.

6. Commutateur électrique selon la revendication 1, 2 ou 3,
**caractérisé en ce que**
le revêtement électriquement isolant (9) se compose d'un film, en particulier un film de plastique, et le film de matière est de préférence collé, laminé ou analogue sur la surface (8) de la pièce métallique (7).

7. Commutateur électrique selon l'une quelconque des revendications 1 à 6,
**caractérisé en ce que**
le revêtement électriquement isolant (9) présente pour des applications en courant continu une rigidité diélectrique d'au moins 400 V et pour des applications en courant alternatif une rigidité diélectrique d'au moins 2000 V.

8. Commutateur électrique selon l'une quelconque des revendications 1 à 7,
**caractérisé en ce que**
la pièce métallique (7) se présente sous la forme d'une plaque, dont l'épaisseur est par exemple d'au moins 2 mm.

9. Commutateur électrique selon l'une quelconque des revendications 1 à 8,
**caractérisé en ce que**
la pièce métallique (7) se présente sous la forme d'un corps de refroidissement, en particulier avec des ailettes de refroidissement (10) sur la surface (8') située à l'opposé du revêtement électriquement isolant (9), et la pièce métallique (7) est de préférence fabriquée à partir d'un corps extrudé.

10. Commutateur électrique selon l'une quelconque des revendications 1 à 9,
**caractérisé en ce que**
les voies conductrices (6) formées sur le revêtement électriquement isolant (9) se composent de cuivre, de palladium-argent ou analogue, les voies conductrices et/ ou les résistances imprimées (14) sont appliquées de préférence sous la forme d'une pâte correspondante, telle qu'une pâte de cuivre, une pâte de palladium-argent, une pâte résistive ou analogue, à la manière d'une technique en couche épaisse sur le revêtement (9) et sont ensuite éventuellement cuites, et le brasage des composants (4) sur le revêtement électriquement isolant (9) est de préférence effectué sous vide.

11. Commutateur électrique selon l'une quelconque des revendications 1 à 10,
**caractérisé en ce qu'**
au moins un composant est un semi-conducteur de puissance (11, 12), le revêtement (9) présente de préférence un creux (13) tel que le semi-conducteur de puissance (11, 12) est fixé directement sur la pièce métallique (7), ou le semi-conducteur de puissance (11, 12) est fixé sur le revêtement (9), et le semi-conducteur de puissance (11, 12) se présente de préférence encore sous la forme d'une puce non enchâssée, qui possède notamment un raccordement métallisé vers la voie conductrice (6) sur le revêtement.

12. Commutateur électrique selon l'une quelconque des revendications 1 à 11,
**caractérisé en ce que**
le commutateur (1) comporte un boîtier (2), et le substrat de support (5) est disposé dans le boîtier (2) et/ou sur un côté du boîtier (2), en particulier sous forme d'une partie de boîtier et/ou de couvercle latéral pour le boîtier (2), de préférence de sorte que la surface (8') de la pièce métallique (7) située à l'opposé du revêtement (9) forme un corps de refroidissement sortant du boîtier (2).

13. Commutateur électrique selon l'une quelconque des revendications 1 à 12,
**caractérisé en ce que**
le substrat de support (5) faisant office de partie de boîtier n'est pas plan et/ou se présente spatialement sous la forme d'un socle (20), de préférence de sorte qu'une autre partie de boîtier, composée en particulier de plastique, soit posée, en particulier de manière étanche, à la manière d'un couvercle (21) pour compléter le boîtier (2).

14. Commutateur électrique selon l'une quelconque des revendications 1 à 13,
**caractérisé en ce que**
le dispositif de circuit (3) comprend au moins un semi-conducteur de puissance, tel qu'un MOS-FET (11) [transistor à effet de champ à grille isolée par une couche d'oxyde de silicium], un triac, un thyristor, une diode roue libre (12) ou analogue, le revêtement (9) présente de préférence au moins un creux (13) tel que le semi-conducteur de puissance (11, 12) est fixé, en particulier brasé, directement sur la pièce métallique (7), et une voie de résistance (14) pour un potentiomètre est de préférence encore déposée sur le revêtement (9), par exemple au moyen d'une pâte résistive à cuire.
